Europäisches Patentamt

European Patent Office

Office européen des brevets

(19)

(11) **EP 1 303 909 B1**

(12) **FASCICULE DE BREVET EUROPEEN**

(45) Date de publication et mention
de la délivrance du brevet:
**24.11.2004 Bulletin 2004/48**

(21) Numéro de dépôt: **01958182.6**

(22) Date de dépôt: **26.07.2001**

(51) Int Cl.$^7$: **H03F 3/217**

(86) Numéro de dépôt international:
**PCT/FR2001/002444**

(87) Numéro de publication internationale:
**WO 2002/011280 (07.02.2002 Gazette 2002/06)**

(54) **CIRCUIT ELECTRONIQUE DE CONVERSION D'UN SIGNAL ET AMPLIFICATEUR INTEGRANT LEDIT CIRCUIT**

ELEKTRONISCHE SIGNALUMSETZUNGSSCHALTUNG UND VERSTÄRKER MIT EINER SOLCHEN SCHALTUNG

ELECTRONIC CIRCUIT FOR CONVERTING A SIGNAL AND AMPLIFIER INCORPORATING SAME

(84) Etats contractants désignés:
**AT BE CH CY DE DK ES FI FR GB GR IE IT LI LU MC NL PT SE TR**

(30) Priorité: **27.07.2000 FR 0009818**

(43) Date de publication de la demande:
**23.04.2003 Bulletin 2003/17**

(73) Titulaires:
• **Lambruschi, René**
**92250 La Garenne-Colombes (FR)**
• **Lomuto, Nicola**
**92700 Colombes (FR)**

(72) Inventeurs:
• **Lambruschi, René**
**92250 La Garenne-Colombes (FR)**
• **Lomuto, Nicola**
**92700 Colombes (FR)**

(74) Mandataire: **Hautier, Jean-Louis**
**Cabinet Hautier**
**Office Méditerranéen de Brevets**
**d'Invention et de Marques**
**24 rue Masséna**
**06000 Nice (FR)**

(56) Documents cités:
**EP-A- 1 003 280**

**Description**

La présente invention concerne d'abord un circuit électronique de conversion d'un signal électrique d'entrée.

Elle concerne également un amplificateur de puissance à découpage d'asservissement en tension.

L'invention trouvera particulièrement son application dans le domaine de la conversion de niveau de signaux électriques.

En particulier, l'amplification de signaux audio de haute fidélité sera possible en mettant en oeuvre la présente invention ainsi que la commande de divers équipements électriques notamment en matière de motorisation pour la robotique.

Dans le domaine de l'amplification audio, les amplificateurs actuels obéissent essentiellement à l'une des deux technologies suivantes.

La première consiste à utiliser deux transistors MOSFET (transistor à effet de champ de technologie métal oxyde silicium) complémentaires montés en source commune.

Bien que permettant l'obtention de bons résultats en matière de qualité audio, de tels montages ne permettent pas d'obtenir de gains importants en puissance.

Une deuxième technologie consiste à employer deux transistors MOSFET tous deux à canal N arrangés en montage totem pole.

L'un de ces transistors est monté en drain commun et l'autre est monté en source commune.

Ce type de montage rencontre un fort succès actuellement dans le domaine de la haute fidélité pour des amplificateurs audio de classe D (amplificateur de puissance à découpage).

Un tel montage en totem pôle a cependant un inconvénient majeur en ce qui concerne la commande des transistors.

En effet, les grilles de chaque transistor MOSFET canal N doivent être commandées par deux signaux de source différente.

De ce fait, des problèmes de synchronisation des signaux de commande se posent. Etant donné que la simultanéité de leur occurrence est impossible à obtenir dans la pratique, on constate des pics de courant lors des commutations.

En effet, il peut arriver suivant ce montage que les deux transistors soient, durant un temps court, actifs simultanément ce qui engendre parfois des pics de courant pouvant atteindre plusieurs centaines d'ampères.

Bien entendu, ces pics de courant importants sont dommageable tant sur le plan du rendement du système que de sa fiabilité.

Pour éviter la présence de pics de courant lors de la commutation, on utilise couramment un temps mort au moment de cette commutation.

On évite ainsi les pics de courant mais en générant d'autres inconvénients.

En effet, l'insertion d'un temps mort engendre des distorsions sur le signal utile.

Par ailleurs, le temps mort ne résout pas le problème du déséquilibre intrinsèque de la configuration en totem pôle : le montage des transistors n'est pas symétrique puisque l'un est monté en drain commun et l'autre monté en source commune.

Par conséquent, les amplificateurs actuels ne donnent pas entière satisfaction puisqu'ils ne permettent pas de trouver un compromis satisfaisant entre le rendement du système et la fidélité obtenue dans l'amplification.

*Dans des technologies voisines de celles évoquées précédemment, on connaît du document FR-A-2.779.293 un circuit de sortie à transistor qui présente une tension supérieure à une tension de claquage de deux transistors NMOS et PMOS utilisés pour construire le circuit de sortie qui sont connectés en série et qui ont leurs grilles connectées l'une à l'autre. Un circuit de commande de potentiel est connecté aux grilles et aux sources de ces transistors. Le circuit de commande de potentiel reçoit de l'énergie depuis des alimentations de potentiels haut et bas. Le circuit de commande de potentiel applique une tension de référence intennédiaire sur les grilles des transistors. Puis en réponse à un signal d'entrée, le circuit de commande de potentiel commande les tensions appliquées sur les sources des transisfors.*

Ce montage n'apporte pas un réel progrès par rapport au montage en totem pole compte tenu que deux signaux de commande sont encore nécessaires.

Par ailleurs, il s'agit uniquement d'un montage en source commune.

La présente invention a pour but de remédier aux inconvénients des dispositifs actuels et, en premier lieu de proposer un circuit assurant à la fois un haut rendement d'amplification et une qualité élevée du signal obtenu.

L'un des premiers avantages de l'invention est d'avoir une seule source de commande de grilles afin d'éviter les problèmes à la commutation.

On ne connaît plus ou très peu le phénomène de pics de courant.

De ce fait, les pertes sont considérablement réduites à ce niveau sans générer une distorsion comme c'est le cas avec l'insertion de temps mort.

Les pertes étant nettement réduites, il est possible d'envisager de larges applications à la présente invention pour obtenir des rendements très élevés tout en intégrant le dispositif sous la forme de modules ou de circuits hybrides de faible encombrement et donc à haut de rapport de puissance sur volume avec des caractéristiques dynamiques supérieures.

Un autre avantage de l'invention est de proposer des moyens de commande qui forment la source de commande de grilles et des transistors sans avoir recours à un transformateur d'isolement.

En conséquence, on ne connaît plus les limitations occasionnées par l'usage d'un transformateur d'isolement et on rend possible une excursion illimitée du rapport cyclique.

On comprend que les avantages ainsi exposés permettent d'envisager de multiples emplois pour la présente invention.

D'autres buts et avantages apparaîtront au cours de la description qui suit qui n'est cependant donnée qu'à titre indicatif et non limitatif de l'invention.

La présente invention concerne un circuit électronique de conversion d'un signal électrique d'entrée, comportant :

- au moins deux transistors de polarités complémentaires et montés au drain commun,
- des moyens de commande des transistors aptes à générer un signal de commande unique pour les grilles desdits transistors,
- une ligne de sortie reliée aux sources desdits transistors.

Sont ci-après énoncées différentes variantes envisagées pour ce circuit :

- les transistors complémentaires sont des transistors à effet de champs de technologie MOS, l'un à canal N, l'autre à canal P.
- le circuit comprend un modulateur de largeur d'impulsion apte à convertir le signal d'entrée en un signal à largeur d'impulsion modulée exploitable par les moyens de commande.
- les moyens de commande comprennent un circuit tampon générant un signal de commande et alimenté par une alimentation de potentiel haut et une alimentation de potentiel de référence.
- l'alimentation de potentiel de référence est la ligne de sortie.
- les moyens de commande comprennent un translateur de niveau constitué par un comparateur connecté en entrée au modulateur de largeur d'impulsion de telle sorte que son entrée inverseuse reçoive le signal (PWM) et que son entrée non inverseuse reçoive un signal inverse du signal (PWM), et connecté en sortie à l'entrée du circuit tampon.
- le comparateur a une alimentation de potentiel haut constituée par l'alimentation de potentiel haut et une alimentation de potentiel bas constituée par la ligne de sortie.
- les moyens de commande comportent en sortie un réseau de polarisation relié en sortie à un générateur courant constant et aux grilles des transistors.
- la liaison entre les grilles des transistors, à la sortie du réseau de polarisation, s'effectue au travers d'un réseau passif d'adaptation de niveau.
- il comprend un filtre pour la filtration du signal de sortie.

L'invention concerne également un amplificateur de puissance à découpage d'asservissement en tension intégrant le circuit selon l'invention.

Les dessins ci-joints sont donnés à titre d'exemples indicatifs et non limitatifs. Ils représentent un mode de réalisation préféré selon l'invention. Ils permettront de comprendre aisément l'invention.

La figure 1 est un schéma général fonctionnel du circuit électronique ici présenté.

La figure 2 est un mode préféré de réalisation de ce circuit suivant un exemple.

L'amplificateur proposé par la présente invention est du type classe D, à découpage d'asservissement en tension.

Le circuit présenté pour sa réalisation comprend au moins deux transistors assurant la conversion de niveau du signal d'entrée In.

Bien que des transistors à effet de champ de technologie MOS (Metal Oxyde Silicium) soient particulièrement visés, l'invention n'est pas limitative à ce niveau et d'autres types de transistors (bipolaires, IGBT, quantique par exemple) pourront être employés.

On décrira ci-après le mode préféré de réalisation où il s'agit de transistors à effet de champ de technologie MOS, dénommés par la suite MOSFET.

De façon connue en matière d'amplificateur en classe D, le signal à amplifier est reçu dans le circuit au niveau d'un modulateur 1 de largeur d'impulsion.

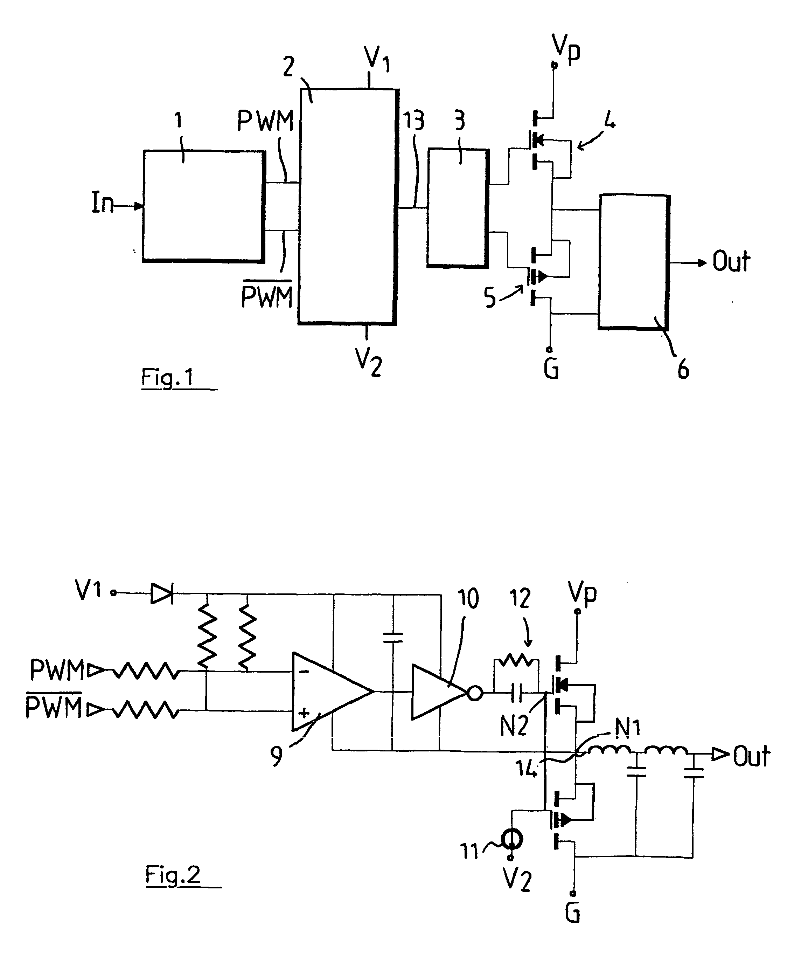

Comme représenté à la figure 1, le modulateur 1 génère un signal carré à largeur d'impulsion modulée (PWM).

Dans le cas de l'invention, ce signal PWM et son complémentaire $\overline{PWM}$ obtenu par tous moyens courants d'inversion constituent l'entrée des moyens de commande repérés 2 à la figure 1.

De façon schématique, cette figure illustre que, par les signaux PWM et $\overline{PWM}$ ainsi que grâce à des alimentations de potentiel haut $V_1$ et bas $V_2$, les moyens de commande 2 forment en sortie un signal de commande 13.

Le signal de commande 13 assure la commande des grilles des deux transistors repérés 4 et 5.

Possiblement, un réseau passif 3 relie les deux grilles afin de réaliser une adaptation de niveau.

Les transistors 4, 5 sont de polarités complémentaires.

Dans le cas de MOSFET, l'une est de type Canal N 4, l'autre canal P 5.

L'alimentation de puissance est constituée entre un potentiel haut $V_p$ connecté au drain du transistor 4, et la terre G, connectée au drain du transistor 5.

En sortie, un filtre 6 est souhaitable. De façon courante dans une application audio, il s'agira par exemple d'un filtre passe-bas de composition capacito-inductive.

On notera que, selon l'invention, le signal 13 est l'unique signal de commande des grilles des transistors 4, 5. On résout ainsi les problèmes de pics à la commutation évoqués précédemment.

Par ailleurs, il apparaît que la ligne de sortie 14 est connectée aux sources des transistors 4, 5.

Le signal de sortie obtenu par ce circuit est repéré en figure 1 par le terme out.

On décrit ci-après plus précisément le mode particulier de réalisation de l'invention illustré à la figure 2.

Un exemple préféré des moyens de commande 2 y est présenté.

Au coeur des moyens de commande 2, un circuit tampon 10 permet la formation d'un signal de commande compatible.

Il reçoit en entrée un signal à largeur d'impulsion modulée. Son alimentation est constituée par une source de potentiel haut $V_1$ et un potentiel de référence.

De façon caractéristique à l'invention, le potentiel de référence est pris sur la ligne de sortie 14. Le circuit tampon 10 est donc relié au noeud N1 commun aux deux sources de transistors 4, 5.

En sortie du circuit tampon 10, un réseau de polarisation 12 est présent. Il permettra de fixer le point de fonctionnement statique du circuit.

A sa sortie, le noeud N2 relie les grilles des transistors 4, 5. Le générateur 11 y délivre un signal électrique à courant constant et place le potentiel bas $V_2$ de l'alimentation de commande. Un autre avantage du circuit ici proposé est, selon une variante préférée, d'utiliser un translateur de niveau de conception particulière.

A cet effet, les moyens de commande 2 comporteront, en amont du circuit tampon 10, un comparateur 9 tel que montré en figure 2.

Comme illustré, l'alimentation du comparateur 9 sera similaire ou dérivée à celle du circuit tampon 10, entre un potentiel haut $V_1$ et le potentiel de référence constitué par la ligne de sortie 14.

Les entrées inverseuse et non inverseuse du comparateur reçoivent respectivement les signaux PWM et $\overline{PWM}$.

L'emploi d'un tel réseau pour former la translation de niveau est avantageuse par rapport à l'utilisation d'un transformateur d'isolement puisqu'il permet une excursion illimitée du rapport cyclique.

On notera que le circuit selon l'invention et l'amplificateur l'intégrant pourront présenter un encombrement particulièrement réduit aux regards des possibilités d'amplification offertes.

La figure 2 montre également un mode de réalisation du filtre 6.

REFERENCES

1.       Modulateur de largeur d'impulsions
2.       Moyens de commande
3.       Réseau de liaison de grilles
4.       Transistor
5.       Transistor
6.       Filtre
7, 8.    Entrées des moyens de commande
9.       Comparateur
10.      Tampon
11.      Générateur
12.      Réseau de polarisation
13.      Signal de commande
14.      Ligne de sortie
in :     signal entrant
out :    signal de sortie
$V_1$ :  potentiel haut de l'alimentation de commande
$V_2$ :  potentiel bas de l'alimentation de commande
$V_p$ :  potentiel haut de la source de puissance
G :      terre puissance
N1 :     noeud 1
N2 :     noeud 2
PWM :    signal à largeur d'impulsion modulé

**Revendications**

1.  Circuit électronique de conversion d'un signal électrique d'entrée (In), comportant :

    -   au moins deux transistors de polarités complémentaires et montés en drain commun,
    -   des moyens de commande (2) des transistors aptes à générer un signal de commande (13) unique pour les grilles desdits transistors,
    -   une ligne de sortie (14) reliée aux sources desdits transistors **caractérisé par le fait**

    **que** les moyens de commande comprennent un circuit tampon (10) adaptant un signal de commande et alimenté par une alimentation de potentiel haut ($V_1$) et une alimentation de potentiel de référence

    et **que** l'alimentation de potentiel de référence est la ligne de sortie (14).

2.  Circuit selon la revendication 1 **caractérisé par le fait**

    **qu'**il comprend un modulateur (1) de largeur d'impulsion apte à convertir le signal d'entrée (In) en un signal (PWM) à largeur d'impulsion modulée exploitable par les moyens de commande (2).

3.  Circuit selon l'une quelconque des revendications 1 ou 2 **caractérisé par le fait**

    **que** les moyens de commande comprennent un translateur de niveau constitué par un comparateur (9) connecté en entrée au modulateur de largeur d'impulsion (1) de telle sorte que son entrée inverseuse reçoive le signal (PWM) et que son entrée non inverseuse reçoive un signal $\overline{PWM}$ inverse du signal (PWM), et connecté en sortie à l'entrée du circuit tampon (10).

4. Circuit selon la revendication 3 **caractérisé par le fait**

que le comparateur (9) a une alimentation de potentiel haut constituée par l'alimentation de potentiel haut V$_1$ et une alimentation de potentiel bas constituée par la ligne de sortie (14).

5. Circuit selon l'une quelconque des revendications 1 à 4

que les moyens de commande comportent en sortie un réseau de polarisation (12) relié en sortie à un générateur (11) de tension à courant constant et aux grilles des transistors.

6. Circuit selon la revendication 5 **caractérisé par le fait**

que la liaison entre les grilles des transistors, à la sortie du réseau de polarisation (12), s'effectue au travers d'un réseau (3) d'adaptation de niveau.

7. Circuit selon l'une quelconque des revendications 1 à 6, **caractérisé par le fait**

qu'il comprend un filtre (6) pour la filtration du signal de sortie (out).

8. Amplificateur de puissance à découpage d'asservissement en tension **caractérisé par le fait**

qu'il intègre le circuit selon l'une quelconque des revendications 1 à 7.


**Patentansprüche**

1. Elektronische Schaltung zur Umwandlung eines elektrischen Eingangssignals (In), bestehend aus:

- mindestens zwei Transistoren mit komplementärer Polarität, die auf einen gemeinsamen Drain gelegt sind,
- Steuereinrichtungen (2) der Transistoren, die zur Erzeugung eines gemeinsamen Steuersignals (13) für die Gitter der genannten Transistoren geeignet sind,
- eine Ausgangsleitung (14), welche an die Quellen der genannten Transistoren angeschlossen ist und **dadurch gekennzeichnet ist,**

**dass** die Steuereinrichtungen eine Tamponschaltung (10) besitzen, die ein Steuersignal anpasst und sowohl mit hohem Potential (V1) sowie mit Referenzpotential versorgt wird und **dass** die Versorgung mit Referenzpotential die Ausgangsleitung (14) ist.

2. Schaltung gemäß Anspruch 1, **gekennzeichnet dadurch, dass** sie einen Modulator (1) mit einer Pulsbreite besitzt, die geeignet ist, das Eingangssignal (In) in ein Signal (PWM) mit modulierter Pulsbreite umzusetzen, das von den Steuereinrichtungen (2) verwertet werden kann.

3. Schaltung gemäß einem der Ansprüche 1 oder 2, **gekennzeichnet dadurch, dass** die Steuereinrichtungen einen Pegel-Umsetzer besitzen, der aus einem Pegel-Komparator (9) besteht, der am Eingang an den Impulsbreitenmodulator (1) angeschlossen ist, so dass sein invertierender Eingang das Signal ($\overline{PWM}$) empfängt und der nicht invertierende Eingang das Signal PWM empfängt, das in bezug auf das Signal (PWM) invertiert ist und dessen Ausgang an den Eingang der Tamponschaltung (10) angeschlossen ist.

4. Schaltung gemäß Anspruch 3, **gekennzeichnet dadurch, dass** der Komparator (9) eine Hochpotentialversorgung bestehend aus der Hochpotentialversorgung V1 und eine Niederpotentialversorgung bestehend aus der Ausgangsleitung (14) besitzt.

5. Schaltung gemäß einem der Ansprüche 1 bis 4, **gekennzeichnet dadurch, dass** die Steuereinrichtungen am Ausgang ein Polarisierungsnetz (12) besitzen, das am Ausgang an einen Spannungsgenerator (11), der konstanten Strom liefert, und die Gitter der Transistore angeschlossen ist.

6. Schaltung gemäß Anspruch 5, **gekennzeichnet dadurch, dass** die Verbindung zwischen den Gittern der Transistoren, am Ausgang des Polarisierungsnetzes (12) über ein Pegelanpassungsnetz (3) erfolgt.

7. Schaltung gemäß einem der Ansprüche 1 bis 6, **gekennzeichnet dadurch, dass** sie einen Filter (6) zur Filterung des Ausgangssignals (out) besitzt.

8. Leistungsverstärker mit Unterbrechung der Spannungsnachführung **gekennzeichnet dadurch, dass** er die Schaltung gemäß einem der Ansprüche 1 bis 7 enthält.


**Claims**

1. Electronic circuit for conversion of an electric input signal (In), comprising:

- At least two transistors of complementary polarities and common drain fitted,
- Means for controlling (2) the transistors capable of generating a single control signal (13) for the gates of the aforesaid transistors,

- An output line (14) connected to the sources of the said transistors

**characterized by** the fact
that the control means include a buffer circuit (10) adapting a control signal and receiving a supply with high potential (V$_1$) and a supply with reference potential
and that the reference potential supply is the output line (14).

2. Circuit according to claim 1 **characterized by** the fact
that it includes a modulator (1) of impulse width capable of converting the input signal (In) into a signal (PWM) with modulated impulse width usable by the control means (2).

3. Circuit according to any one of claims 1 or 2 **characterized by** the fact
that the control means include a level translator consisting of a comparator (9) connected to the impulse width modulator (1) so that its inverting input receives the signal (PWM) and that its non-inverting input receives a $\overline{PWM}$ signal, inverse of signal (PWM), and connected at the output of buffer circuit (10).

4. Circuit according to claim 3 **characterized by** the fact
that the comparator (9) has a high voltage feed consisting of high voltage feed V$_1$ and low voltage feed comprising the output line (14).

5. Circuit according to any of claims 1 to 4 **characterized by** the fact
that the control means include a polarization network (12) at the output connected to a constant current voltage generator (11) and the transistor gates.

6. Circuit according to claim 5 **characterized by** the fact
that the connection between the transistor gates at the polarization network output (12), takes place through a level adaptation network (3).

7. Circuit according to any of claims 1 to 6, **characterized by** the fact
that it includes a filter (6) for filtering the output signal (out).

8. Power amplifier with voltage automatic control decoupling **characterized by** the fact
that it integrates the circuit according to any of claims 1 to 7.

EP 1 303 909 B1

Fig.1

Fig.2